Europäisches Patentamt

European Patent Office

Office européen des brevets

(19)

(11) Publication number: **0 137 721**
**B1**

(12)

# EUROPEAN PATENT SPECIFICATION

(45) Date of publication of patent specification: **15.03.89**

(51) Int. Cl.⁴: **G 11 B 5/09**

(21) Application number: **84306102.9**

(22) Date of filing: **06.09.84**

(54) Digital data recording and reproducing devices.

(30) Priority: **08.09.83 JP 165677/83**

(43) Date of publication of application:
**17.04.85 Bulletin 85/16**

(45) Publication of the grant of the patent:
**15.03.89 Bulletin 89/11**

(84) Designated Contracting States:
**AT DE FR GB NL**

(56) References cited:
**EP-A-0 092 403**
**DE-A-2 944 403**
**GB-A-1 586 093**
**GB-A-2 097 985**

(73) Proprietor: **SONY CORPORATION**
**7-35 Kitashinagawa 6-Chome Shinagawa-ku**
**Tokyo 141 (JP)**

(72) Inventor: **Suma, Tetsuro c/o Sony Corporation**
**Patents Division 7-35 Kitashinagawa 6-chome**
**Shinagawa-ku Tokyo (JP)**
Inventor: **Abe, Takao c/o Sony Corporation**
**Patents Division 7-35 Kitashinagawa 6-chome**
**Shinagawa-ku Tokyo (JP)**
Inventor: **Ogawa, Tetsuo c/o Sony Corporation**
**Patents Division 7-35 Kitashinagawa 6-chome**
**Shinagawa-ku Tokyo (JP)**

(74) Representative: **Cotter, Ivan John et al**
**D. YOUNG & CO. 10 Staple Inn**
**London WC1V 7RD (GB)**

## Description

This invention relates to digital data recording and reproducing devices, for example digital video tape recorders for recording and reproducing digital video signals.

UK Patent Specification No. GB—A—1 586 093 discloses a digital data recording and reproducing device for recording and reproducing data comprising code words of M bits, the device comprising:

first redundant code generating means for generating a first redundant code from an upper $m_1$ bits on the most significant bit side with great weighting in the M bits;

first redundant code adding means for adding the first redundant code to the upper $m_1$ bits;

second redundant code generating means for generating a second redundant code from a lower $m_2$ bits on the least significant side with small weighting in the M bits;

second redundant code adding means for adding the second redundant code to the lower $m_2$ bits;

signal recording means for recording a recording data signal, with said first and second redundant codes added thereto, on a recording medium;

signal reproducing means for reproducing a reproduced data signal from the recording medium; and

signal processing means including first error detecting means for detecting an error of the upper $m_1$ bits of the reproduced data signal according to the first redundant code of the reproduced data signal and second error detecting means for detecting an error of the lower $m_2$ bits of the reproduced data signal according to the second redundant code of the reproduced data signal.

Usually, in a digital video tape recorder, digital video signals are recorded together with redundant bits for protecting digital video signals transmitted through a recording and reproducing arrangement. In such arrangement, the reproduced digital video signal obtained in a reproducing system is processed for data error correction using the redundant bits. Subsequently, a check is carried out as to whether there is any error in the corrected data and, if necessary, an error concealment operation is effected, in which erroneous data that could not have been corrected by the data error correction operation is interpolated from adjacent correct data.

In a previously proposed digital video tape recorder, the error concealment operation is performed by making a check as to whether there is any error in the reproduced digital video signal using the same judgement level during a reproducing operation at a different tape speed from the tape speed at the time of the recording, as that during the normal reproducing operation. However, in a tape recorder of helical scan type utilising a rotary head, a great deal of signal omission usually take place during the different speed reproducing operation. For this reason, when a digital video signal is dealt with, the absolute amount of data decided to be free from error is not present in the reproduced digital signal, so that sufficient error concealment cannot be obtained and considerable errors appear in the signal as reproduced on a screen.

According to one aspect of the present invention there is provided a digital data recording and reproducing device for recording and reproducing data comprising code words of M bits, the device comprising:

first redundant code generating means for generating a first redundant code from an upper $m_1$ bits on the most significant bit side with great weighting in the M bits;

first redundant code adding means for adding the first redundant code to the upper $m_1$ bits;

second redundant code generating means for generating a second redundant code from a lower $m_2$ bits on the least significant side with small weighting in the M bits;

second redundant code adding means for adding the second redundant code to the lower $m_2$ bits;

signal recording means for recording a recording data signal, with said first and second redundant codes added thereto, on a recording medium;

signal reproducing means for reproducing a reproduced data signal from the recording medium; and

signal processing means including first error detecting means for detecting an error of the upper $m_1$ bits of the reproduced data signal according to the first redundant code of the reproduced data signal and second error detecting means for detecting an error of the lower $m_2$ bits of the reproduced data signal according to the second redundant code of the reproduced data signal;

characterised in that the signal reproduction can be effected in different operational modes corresponding to different reproduction speeds and in that control means is provided for selecting the operational mode of signal reproduction and also for switching the operation of the signal processing means according to the selected operational mode of signal reproduction, the control means being operative to hold the second error detecting means inoperative during an operational mode of signal reproduction in which reproduction of data is carried out at a different speed from that employed during recording.

According to another aspect of the present invention there is provided a digital data recording and reproducing device for recording and reproducing data comprising code words of M bits, the device comprising:

first redundant code generating means for generating a first redundant code from an upper $m_1$ bits on the most significant bit side with great weighting in the M bits;

first redundant code adding means for adding the first redundant code to the upper $m_1$ bits;

second redundant code generating means for generating a second redundant code from a lower $m_2$ bits on the least significant side with small weighting in the M bits;

second redundant code adding means for adding the second redundant code to the lower $m_2$ bits;

signal recording means for recording a recording data signal, with said first and second redundant codes added thereto, on a recording medium;

signal reproducing means for reproducing a reproduced data signal from the recording medium; and

signal processing means including first error detecting means for detecting an error of the upper $m_1$ bits of the reproduced data signal according to the first redundant code of the reproduced data signal, second error detecting means for detecting an error of the lower $m_2$ bits of the reproduced data signal according to the second redundant code of the reproduced data signal, and concealing means for concealing an error in the reproduced data signal;

characterised in that the signal reproduction can be effected in different operational modes corresponding to different reproduction speeds and in that control means is provided for selecting the operational mode of signal reproduction and also for switching the operation of the signal processing means according to the selected operational mode of signal reproduction, such that the concealing means is operatively only according to a detection result of the first error detecting means during an operational mode of signal reproduction in which reproduction of data is carried out at a different speed from that employed during recording.

A device embodying the present invention and described hereinbelow was designed in the light of the above problem in the different speed reproducing operation of the previously proposed digital video tape recorder, and adopts a signal processing technique in which the detection of an error in data with weighting provided with a code word dissolution of M bits is performed with only upper bits of greater weighting. In the previously proposed arrangement, of the reproduced data with many errors obtained in the different speed reproducing operation of the helical scan type video tape recorder, those items of data which include an error in the lower bits are discarded. According to the present preferred device, such data is adopted as effective data, and generation of errors that are noticeable in the reproduction on the screen are reliably suppressed, while ignoring lower bit errors which have less adverse effects, thus permitting a different speed reproduction which permits a satisfactory image quality to be obtained on the screen as a whole.

The invention will now be further described, by way of illustrative example, with reference to the accompanying drawings, in which:

Figure 1 is a block diagram showing a recording system of a digital data recording and reproducing device embodying the present invention, applied to a digital video tape recorder;

Figure 2 is a block diagram showing a specific example of an error processing encoder provided in the recording system;

Figure 3 is a block diagram showing a reproducing system of the device embodying the invention;

Figure 4 is a block diagram showing a specific example of an error processing circuit provided in the reproducing system; and

Figures 5 to 7 are views for explaining the probability of occurrence of errors in data by comparing a previously proposed code format and a code format that can be used in the device embodying the present invention, Figure 5 showing the previously proposed code format, Figure 6 showing the code format used in the embodiment of the invention, and Figure 7 being a graph showing characteristic curves representing the results of calculations of probability for the two code formats.

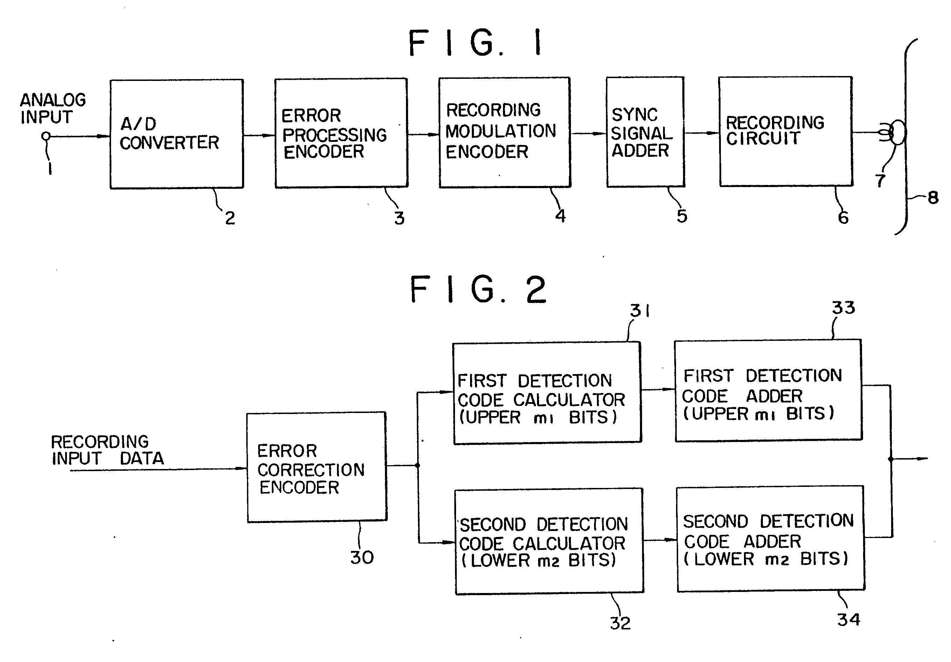

Figure 1 is a block diagram showing a recording system of a digital data recording and reproducing device embodying the present invention, applied to a digital video tape recorder of helical scan type.

In this embodiment, an analog input video signal is supplied to a signal input terminal 1 and thence to an analog-to-signal (A/D) converter 2. The A/D converter 2 converts the input analog signal to a digital video signal, the data of which is provided with weights from the most significant bit (MSB) to the least significant bit (LSB), with M bits in one sample. The M-bit digital video signal data (hereinafter referred to as recording input data) obtained from the A/D converter 2 is supplied to an error processing encoder 3.

The error processing encoder 3, as shown in Figure 2, includes an error correction encoder 30, first and second detection code calculators 31 and 32 and first and second detection code adders 33 and 34. The error correction encoder 30 adds a general error correction code such as a cyclic redundancy check code (CRCC) as a redundant bit to the recording input data (comprising M bits for one sample) supplied from the A/D converter 2. The recording input data, after the error correction code has been added thereto in the error correction encoder 30, is supplied to the first and second detection code calculators 31 and 32. The first detection code calculator 31 calculates from the recording input data a first detection code for detecting an error in data of upper $m_1$ bits of great weighting on the MSB side during a reproducing operation to be described later. The first detection code adder 33 adds the first detection code (calculated by the first detection code calculator 31) as a redundant bit to the data of the upper $m_1$ bits. Likewise, by means of the second detection code calculator 32 and second detection code adder 34, a second detection code is calculated with respect to the data of lower $m_2$ bits of small weighting on the LSB side in the recording input data, and the second detection code is added as a redundant bit.

The recording input data, after the error correction code and detection codes have been added thereto in the error processing encoder 3, is sent through a recording modulation encoder 4 for encoding processing, including reduction of the *dc* component. An output of the recording modulation encoder 4 is supplied to a synchronising signal adder 5 for addition thereto of a synchronising signal bit before it is supplied to a recording circuit 6. The recording circuit 6 performs recording equalization and recording amplification of the recording input data supplied from the synchronising signal adder 5. The resultant recording input data from the recording circuit 6 is supplied to a rotary recording head 7. The recording input data supplied to the recording head 7 is recorded as slanting recording tracks on a magnetic tape 8.

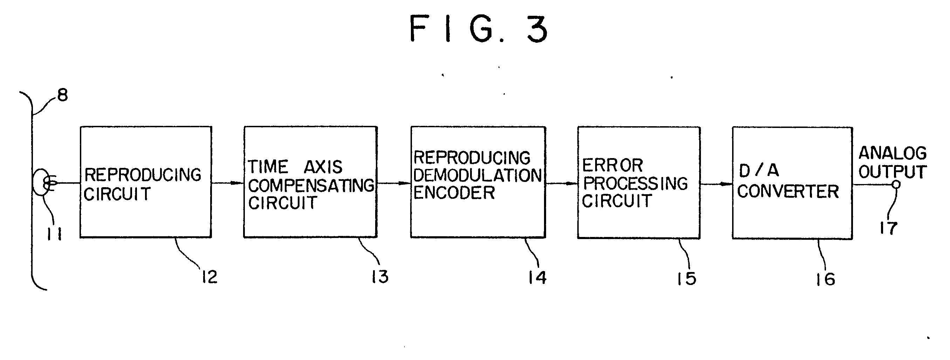

Figure 3 is a block diagram showing a reproducing system of the device embodying the invention.

In this embodiment, a signal reproduced from the magnetic tape 8 by a rotary reproducing head 11 is supplied to a reproducing circuit 12. The reproducing circuit 12 performs reproducing amplification and reproducing equalisation to reproduce clock information and data.

The reproduced data obtained from the reproducing circuit 12 is supplied to a time axis compensating circuit 13 for removal of a jitter component. The time axis compensating circuit 13 also functions to form a synchronising signal from synchronising bits in the reproduced data.

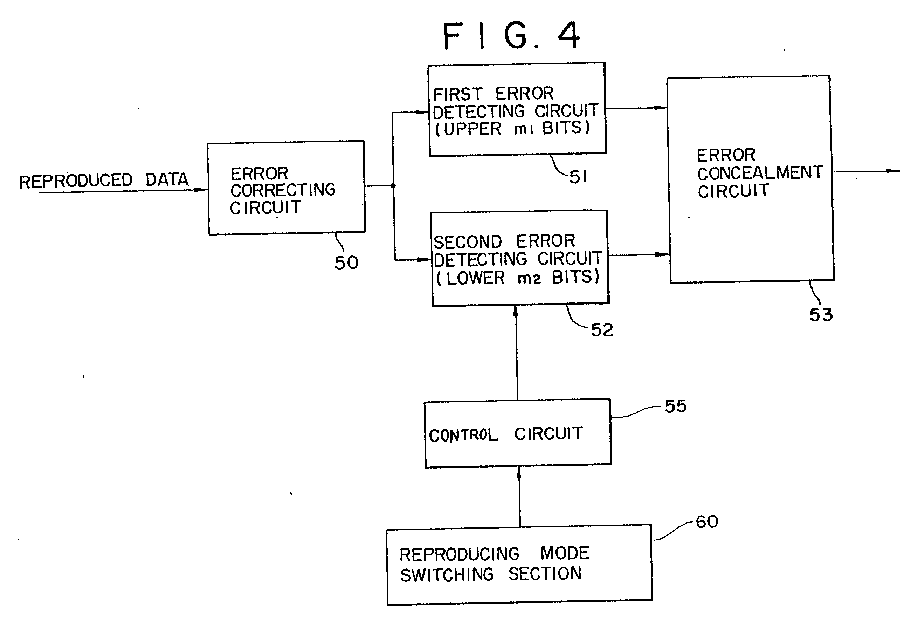

The reproduced data, after removal therefrom of the jitter component by the time axis compensating circuit 13, is supplied through a reproducing demodulation encoder 14 to an error processing circuit 15. The error processing circuit 15 performs an error processing operation. As shown in Figure 4, the error processing circuit 15 includes an error correcting circuit 50, first and second error detecting circuits 51 and 52 and first and second error concealment circuits 53. The reproduced data is supplied through the error correcting circuit 50 to the error detecting circuits 51 and 52. The error correcting circuit 50 performs error correction of the input reproduced data on the basis of the correction code added as a redundant bit. The first error detecting circuit 51 performs error detection of the error-corrected reproduced data from the error correcting circuit 50 on the basis of the first detecting signal added as redundant bits to the MSB side upper $m_1$ bits. Likewise, the second error detecting circuit 52 performs error detection of the same error-corrected reproduced data on the basis of the second detecting signal added as redundant bits to the LSB side lower $m_2$ bits. When a detection signal is supplied from either the first error detecting circuit 51 or the second error detecting circuit 52, the error concealment circuits 53, which may be in the form of an error correcting circuit, perform error concealment of the supplied reproduced data.

The second error detecting circuit 52 can be switched by a control circuit 55, which is interlocked with a reproducing mode switching section 60 of the video tape recorder such that it performs the error detecting operation as noted above during the normal reproducing operation mode but does not perform any error detecting operation during the different speed reproducing operation mode.

Referring again to Figure 3, the error-corrected reproduced data obtained from the error processing circuit 15 is supplied to a digital-to-analog (D/A) converter 16 for conversion to an analog reproduced video signal which is provided at a signal output terminal 17.

In the video data recorder of the above-described construction, error detection is performed with respect to all of the M bits of the upper $m_1$ bits and lower $m_2$ bits of the reproduced data during the normal reproducing operation mode. That is, error detection with reference to the same judgement reference as in the above-described previous proposal is performed. In this way, error concealment can be obtained.

During the different speed reproducing operation mode, error detection is performed only with respect to the upper $m_1$ bits (i.e. the MSB side data of greater weighting) of the reproduced data. In this way, error concealment alleviating the judgement reference can be obtained. If there is any error in the lower $m_2$ bits (i.e. the LSB side data of smaller weighting) of the reproduced data, it has no substantial effect on the image quality of the reproduced image. By performing the error concealment operation as described above only on the MSB side data that significantly influences the image quality of the reproduced image, the probability that all the M-bit reproduced data will be judged to be erroneous can be reduced. Thus, it is possible to ensure a great quantity of effective data and improve the image quality by the error concealment operation.

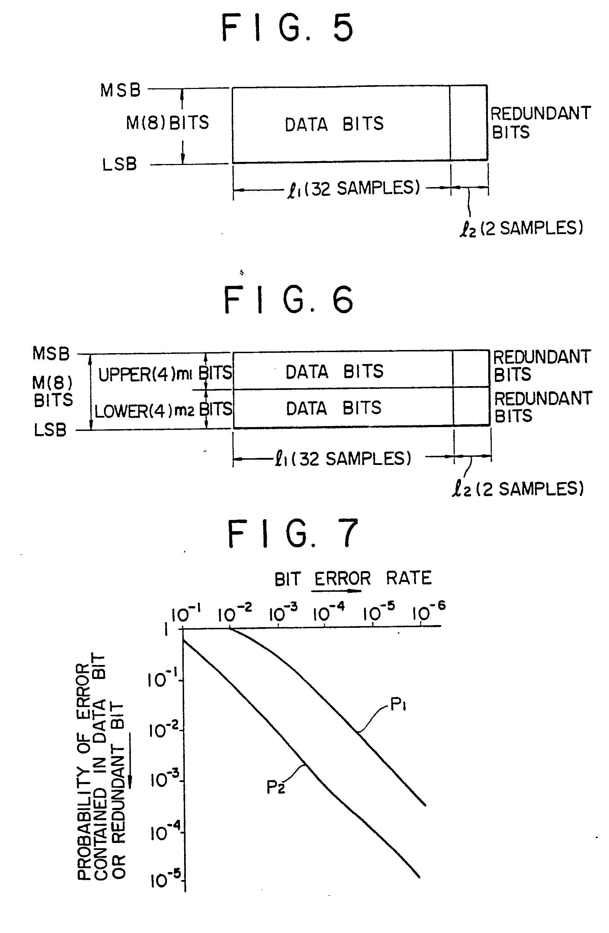

The probability of an error being generated in the M-bit data in the above embodiment will now be compared to that in the case of the above-described previous proposal. In the case where data comprising M bits for one sample is dealt with such that a data length of $l_1$ samples is handled as one data block and the redundant bits for $l_2$ samples are added to one data block, the probability $P_1$ that an error is contained in the data bits or redundant bits can be expressed in the case of a previously proposed code format as shown in Figure 5 as:

$$P_1 = 1 - (1 - P_{SE})^{(l_1 + l_2)} \qquad (1).$$

In the case of a code format used in the above-described embodiment, as shown in Figure 6, the probability $P_2$ is

$$P_2 = 1 - (1 - P_{SE4})^{(l_1 + l_2)} \qquad (2).$$

In Equation (1), $P_{SE}$ represents a sample error rate in the data bits or redundant bits. Denoting the bit error of such data bits or redundant bits by $P_{BE}$,

$$P_{SE} = 1 - (1 - P_{BE})^{M/SAMPLE} \qquad (3).$$

In Equation (2), $P_{SE4}$ represents an equivalent sample rate in the case of the code format shown in Figure 6. In the case when $M=8$ and $m_1 = m_2 = 4$,

$$P_{SE4} = 1 - \sqrt{1 - P_{SE}} \qquad (4).$$

When the probabilities $P_1$ and $P_2$ are calculated by substituting $l_1 = 32$ samples and $l_2 = 2$ samples, the probabilities $P_1$ and $P_2$ are expressed as respective characteristic curves in the graph of Figure 7, where the abscissa represents the bit error rate $P_{BE}$.

## Claims

1. A digital data recording and reproducing device for recording and reproducing data comprising code words of M bits, the device comprising:

first redundant code generating means (31) for generating a first redundant code from an upper $m_1$ bits on the most significant bit side with great weighting in the M bits;

first redundant code adding means (33) for adding the first redundant code to the upper $m_1$ bits;

second redundant code generating means (32) for generating a second redundant code from a lower $m_2$ bits on the least significant side with small weighting in the M bits;

second redundant code adding means (34) for adding the second redundant code to the lower $m_2$ bits;

signal recording means (6) for recording a recording data signal, with said first and second redundant codes added thereto, on a recording medium (8);

signal reproducing means (12) for reproducing a reproduced data signal from the recording medium (8); and

signal processing means (15) including first error detecting means (51) for detecting an error of the upper $m_1$ bits of the reproduced data signal according to the first redundant code of the reproduced data signal and second error detecting means (52) for detecting an error of the lower $m_2$ bits of the reproduced data signal according to the second redundant code of the reproduced data signal;

characterised in that the signal reproduction can be effected in different operational modes corresponding to different reproduction speeds and in that control means (55, 60) is provided for selecting the operational mode of signal reproduction and also for switching the operation of the signal processing means (15) according to the selected operational mode of signal reproduction, the control means (55, 60) being operative to hold the second error detecting means (52) inoperative during an operational mode of signal reproduction in which reproduction of data is carried out at a different speed from that employed during recording.

2. A digital data recording and reproducing device for recording and reproducing data comprising code words of M bits, the device comprising:

first redundant code generating means (31) for generating a first redundant code from an upper $m_1$ bits on the most significant bit side with great weighting in the M bits;

first redundant code adding means (33) for adding the first redundant code to the upper $m_1$ bits;

second redundant code generating means (32) for generating a second redundant code from a lower $m_2$ bits on the least significant side with small weighting in the M bits;

second redundant code adding means (34) for adding the second redundant code to the lower $m_2$ bits;

signal recording means (6) for recording a recording data signal with said first and second redundant codes added thereto, on a recording medium (8);

signal reproducing means (12) for reproducing a reproduced data signal from the recording medium (8); and

signal processing means (15) including first error detecting means (51) for detecting an error of the upper $m_1$ bits of the reproduced data signal according to the first redundant code of the reproduced data signal, second error detecting means (52) for detecting an error of the lower $m_2$ bits of the reproduced data signal according to the second redundant code of the reproduced data signal, and concealing means (53) for concealing an error in the reproduced data signal;

characterised in that the signal reproduction can be effected in different operational modes corresponding to different reproduction speeds and in that control means (55, 60) is provided for selecting the operational mode of signal reproduction and also for switching the operation of the signal processing means (15) according to the selected operational mode of signal reproduction, such that the concealing means (53) is operative only according to a detection result of the first error detecting means 51 during an operational mode of signal reproduction in which reproduction of data is carried out at a different speed from that employed during recording.

3. A device according to claim 1 or claim 2, wherein the control means (55, 60) is operative to switch the operation of the signal processing means (15) by switching the operation of the first and second error detecting means (51, 52).

4. A device according to any one of the preceding claims, which is capable of recording and reproducing data which is in the form of a digital video signal, wherein a rotary head (7, 11) is provided for tracing slanting recording tracks on a recording medium (8) in the form of a magnetic tape for recording and reproducing the digital video signal.

5. A device according to any one of the preceding claims, wherein the first redundant code is a first error detection code and the second redundant code is a second error detection code, the first error detecting means (51) is operative to detect an error of the upper $m_1$ bits of the reproduced data signal according to the first detection code of the reproduced data signal so as to produce a first detection signal, and the second error detecting means (52) is operative to detect an error of the lower $m_2$ bits of the reproduced data signal according to the second detection code of the reproduced data signal so as to produce a second detection signal.

6. A device according to claim 5, as appendant to claim 1 or any one of claims 3 and 4 as appendant to claim 1, incuding concealing means (53) for concealing an error in the reproduced data signal when either the first or the second detection signal is produced.

7. A device according to claim 2 or claim 6, wherein the concealing means (53) comprises a correcting circuit.

**Patentansprüche**

1. Aufzeichnungs- und Wiedergabevorrichtung für Digitaldaten zum Aufzeichnen und Wiedergeben von Daten mit Codewörtern aus M-Bits,

mit einer ersten Redundanzcode-Erzeugungseinrichtung (31) zur Erzeugung eines ersten Redundanzcodes aus höherwertigen $m_1$ Bits der Seite des höchstwertigen Bits mit großer Gewichtung in den M Bits,

mit einer ersten Redundancode-Addiereinrichtung (33) zum Addieren des ersten Redundanzcodes zu den höherwertigen $m_1$ Bits,

mit einer zweiten Redundanzcode-Erzeugungseinrichtung (32) zur Erzeugung eines zweiten Redundanzcodes aus niederwertigeren $m_2$ Bits der Seite des niedrigstwertigen Bits mit geringer Gewichtung in den M Bits,

mit einer zweiten Redundanzcode-Addiereinrichtung (34) zum Addieren des zweiten Redundanzcodes zu den niederwertigeren $m_2$ Bits,

mit einer Signal-Aufzeichnungseinrichtung (6) zum Aufzeichnen eines Aufzeichnungs-Datensignals mit hinzugefügtem ersten und zweiten Redundanzcode auf ein Aufzeichnungsmedium (8),

mit einer Signal-Wiedergabeeinrichtung (12) zur Wiedergabe eines von einem Aufzeichnungsmedium (8) wiedergegebenen Datensignals und

mit einer Signal-Verarbeitungseinrichtung (15), die einer erste Fehlererfassungseinrichtung (51) zur Erfassung einers Fehlers der höherwertigen $m_1$ Bits des wiedergegebenen Datensignals abhängig von dem ersten Redundanzcode des wiedergegebenen Datensignals und

eine zweite Fehlererfassungseinrichtung (52) aufweist zur Erfassung eines Fehlers der niederwertigeren $m_2$ Bits des wiedergegebenen Datensignals abhängig von dem zweiten Redundanzcode des wiedergegebenen Datensignales, dadurch gekennzeichnet, daß die Signalwiedergabe verschiedenen Wiedergabegeschwindigkeiten entsprechend in verschiedenen Betriebsarten ausführbar ist,

daß eine Steuereinrichtung (55, 60) vorgesen ist, zum Wählen der Betriebsart der Signalwiedergabe sowie zum Schalten des Betriebes der Signal-Verarbeitungseinrichtung (15) abhängig von der gewählten Betriebsart der Signalwiedergabe und

daß die Steuereinrichtung (55, 60) die zweite Fehlererfassungseinrichtung (52) während einer Betriebsart der Signalewidergabe, in der Wiedergabe von Daten mit von der Aufzeichnungsgeschwindigkeit unterschiedlicher Geschwindigkeit ausgeführt wird, funktionsunfähig hält.

2. Aufzeichnungs- und Wiedergabevorrichtung für Digitaldaten zum Aufzeichnen und Wiedergeben von Daten mit Codewörtern aus M-Bits,

mit einer ersten Redundanzcode-Erzeugungseinrichtung (31) zur Erzeugung eines ersten Redundanzcodes aus höherwertigen $m_1$ Bits der Seite des höchstwertigen Bits mit großer Gewichtung in den M Bits,

mit einer ersten Redundanzcode-Addiereinrichtung (33) zum Addieren des ersten Redundanzcodes zu den höherwertigen $m_1$ Bits,

mit einer zweiten Redundanzcode-Erzeugungseinrichtung (32) zur Erzeugung eines zweiten Redundanzcodes aus niederwertigeren $m_2$ Bits der Seite des niedrigstewertigen Bits mit geringer Gewichtung in den M Bits,

mit einer zweiten Redundanzcode-Addiereinrichtung (34) zum Addieren des zweiten Redundanzcodes zu den niederwertigeren $m_2$ Bits,

mit einer Signal-Aufzeichnngseinrichtung (6) zum Aufzeichnen eines Aufzeichnungs-Datensignals mit hinzugefügtem ersten und zweiten Redundanzcode auf ein Aufzeichnungsmedium (8),

mit einer Signal-Wiedergabeeinrichtung (12) zur Wiedergabe eines von einem Aufzeichnungsmedium (8) wiedergegebenen Datensignals und

mit einer Signal-Verarbeitungseinrichtung (15), die einer erste Fehlererfassungseinrichtung (51) zur Erfassung eines Fehlers der höherwertigen $m_1$ Bits des wiedergegebenen Datensignals abhängig von dem ersten Redundanzcode des wiedergegebenen Datensignals,

eine zweite Fehlererfassungseinrichtung (52) zur Erfassung eines Fehlers der niederwertigeren $m_2$ Bits des wiedergegebenen Datensignals anhängig von dem zweiten Redundanzcode des wiedergegebenen Datensignales, und

eine Verdeckungseinrichtung (53) aufweist zum Verdecken eines Fehlers in dem wiedergegebenen Datensignal, dadurch gekennzeichnet,

daß die Signalwiedergabe verschiedenen Wiedergabegeschwindigkeiten entsprechend in verschiedenen Betriebsarten ausführbar ist,

daß eine Steuereinrichtung (55, 60) vorgesehen ist zum Wählen der Betriebsart der Signalwiedergabe sowie zum Schalten des Betriebes der Signal-Verarbeitungseinrichtung (15) abhängig von der gewählten Betriebsart der Signalwiedergabe derart,

daß die Fehler-Verdeckungseinrichtung (53) nur gemäß einem Erfassungsergebnis der ersten Fehlererfassungseinrichtung (51) während einer Betriebsart der Signalwiedergabe, in der Wiedergabe von Daten mit von der Aufzeichnungsgeschwindigkeit unterschiedlicher Geschwindigkeit ausgeführt wird, arbeitet.

3. Vorrichtung nach Anspruch 1 oder 2, bei der die Steuereinrichtung (55, 60) durch Schalten des Betriebes der ersten und zweiten Fehlererfassungseinrichtung (51, 52) den Betrieb der Signal-Verarbeitungseinrichtung (15) schaltet.

4. Vorrichtung nach einem der vorhergehenden Ansprüche, die in Form eines digitalen Videosignales vorliegende Daten aufzeichnen und wiedergeben kann, bei der ein rotierender Kopt (7, 11) vorgesehen ist zum Verfolgen schräger Aufzeichnungsspuren auf einem Aufzeichnungsmedium (8) in Form eines Magnetbandes zum Aufzeichnen und Wiedergeben des digitalen Videosignals.

5. Vorrichtung nach einem der vorhergehenden Ansprüche, bei der der erste Redundanzcode einer erster Fehlererfassingscode und der zweite Redundanzcode ein zweiter Fehlererfassungscode ist, die ein erstes Erfassungssignal erzeugende erste Fehlererfassungseinrichtung (51) einen Fehler der höherwertigen $m_1$ Bits des wiedergegebenen Datensignales abhängig von dem ersten Erfassungscode des wiedergegebenen Datensignales erfaßt, und die ein zweites Erfassungssignal erzeugende zweite Fehlererfassungseinrichtung (52) einen Fehler der niederwertigeren $m_2$ Bits des wiedergegebenen Datensignales abhängig von dem zweiten Erfassungscode des wiedergegebenen Datensignales erfaßt.

6. Vorrichtung nach Anspruch 5 oder einem der Ansprüche 3 oder 4, jeweils abhängig von Anspruch 1, mit einer Verdeckungseinrichtung (53) zum Verdecken eines Fehlers im wiedergegebenen Datensignal, wenn entweder das erste oder das zweite Erfassungssignal erzeugt ist.

7. Vorrichtung nach Anspruch 2 oder 6, bei der die Verdeckungseinrichtung (53) eine Korrekturschaltung aufweist.

**Revendications**

1. Dispositif d'enregistrement et de reproduction de données numériques pour enregistrer et reproduire des données comprenant des mots de codes de M bits, le dispositif comprenant:

un premier moyen générateur de code redondant (31) pour générer un premier code redondant à partir d'un groupe supérieur de $m_1$ bits du côté du bit de poids le plus fort de grande pondération parmi les M bits;

un premier moyen d'addition de code redondant (33) pour additionneur le premier code redondant avec les $m_1$ bits de poids fort;

un deuxième moyen générateur de code redondant (32) pour générer un deuxième code redondant à partir d'un groupe inférieur de $m_2$ bits du côté du bit de poids le plus faible de petite pondération parmi les M bits;

un deuxième moyen d'addition de code redondant (34) pour additionner le deuxième code redondant avec les $m_2$ bits de poids faible;

un moyen d'enregistrement de signaux (6) pour enregistrer un signal de données d'enregistrement, avec les premier et deuxième codes redondants additionnés avec celui-ci, sur un support d'enregistrement (8);

un moyen de reproduction de signaux (12) pour reproduire un signal de données reproduites à partir du support d'enregistrement (8); et

un moyen de traitement de signaux (15) incluant un premier moyen de détection d'erreur (51) pour détecter une erreur des $m_1$ bits de poids fort du signal de données reproduites selon le premier code redondant du signal de données reproduites et un deuxième moyen de détection d'erreur (52) pour détecter une erreur des $m_2$ bits de poids faible du signal de données reproduites selon le deuxième code redondant du signal de données reproduites;

caractérisé en ce que la reproduction de signaux peut être réalisée dans des modes fonctionnels différents correspondant à différentes vitesses de reproduction et en ce qu'un moyen de commande (55, 60) est prévu pour sélectionner le mode fonctionnel de reproduction de signaux et également pour changer le fonctionnement du moyen de traitement de signaux (15) selon le mode fonctionnel de reproduction de signaux sélectionné, le moyen de commande (55, 60) étant actif pour maintenir le deuxième moyen de détection d'erreur (52) inactif pendant un mode fonctionnel de reproduction de signaux dans lequel la reproduction de données est réalisée à une vitesse différente de celle utilisée pendant un enregistrement.

2. Dispositif d'enregistrement et de reproduction de données numériques pour enregistrer et reproduire des données comprenant des mots de codes de M bits, le dispositif comprenant:

un premier moyen générateur de code redondant (31) pour générer un premier code redondant à partir d'un groupe supérieur de $m_1$ bits du côté du bit de poids le plus fort de grande pondération parmi les M bits;

un premier moyen d'addition de code redondant (33) pour additionner le premier code redondant avec les $m_1$ bits de poids fort;

un deuxième moyen générateur de code redondant (32) pour générer un deuxième code redondant à partir d'un groupe inférieur de $m_2$ bits du côté du bit de poids le plus faible de petite pondération parmi les M bits;

un deuxième moyen d'addition de code redondant (34) pour additionner le deuxième code redondant avec les $m_2$ bits de poids faible;

un moyen d'enregistrement de signaux (6) pour enregistrer un signal de données d'enregistrement, avec les premier et deuxième codes redondants additionnés avec celui-ci, sur un support d'enregistrement (8);

un moyen de reproduction de signaux (12) pour reproduire un signal de données reproduites à partir du support d'enregistrement (8); et

un moyen de traitement de signaux (15) incluant un premier moyen de détection d'erreur (51) pour détecter une erreur des $m_1$ bits de poids fort du signal de données reproduites selon le premier code redondant du signal de données reproduits, un deuxième moyen de détection d'erreur (52) pour détecter une erreur des $m_2$ bits de poids faible du signal de données reproduites selon le deuxième code redondant du signal de données reproduites, et un moyen de dissimulation (53) pour dissimuler une erreur dans le signal de données reproduites;

caractérisé en ce que la reproduction de signaux peut être effectuée dans différents modes fonctionnels correspondant à différentes vitesses de reproduction et en ce qu'un moyen de commande (55, 60) est prévu pour sélectionner le mode fonctionnel de reproduction de signaux et également pour changer le fonctionnement du moyen de traitement de signaux (15) selon le mode fonctionnel de reproduction de signaux sélectionné, de telle sorte que le moyen de dissimulation (53) n'est actif que selon un résultat de détection du premier moyen de détection d'erreur (51) pendant un mode fonctionnel de reproduction de signaux dans lequel la reproduction de données est réalisée à une vitesse différente de celle utilisée pendant un enregistrement.

3. Dispositif selon l'une quelconque des revendications 1 et 2, dans lequel le moyen de commande (55, 60) est actif pour changer le fonctionnement du moyen de traitement de signaux (15) en commutant le fonctionnement des premier et deuxième moyens de détection d'erreur (51, 52).

4. Dispositif selon l'une quelconque des revendications 1 à 3, qui permet d'enregistrer et de reproduire des données qui sont sous la forme d'un signal vidéo numérique, dans lequel une tête rotative (7, 11) est prévue pour suivre des pistes d'enregistrement obliques sur un support d'enregistrement (8) ayant la forme d'une bande magnétique pour enregistrer et reproduire le signal vidéo numérique.

5. Dispositif selon l'une quelconque des revendications 1 à 4, dans lequel le premier code redondant est un premier code de détection d'erreur et le deuxième code redondant est un deuxième code de détection d'erreur, le premier moyen de détection d'erreur (51) est actif pour détecter une erreur des $m_1$ bits de poids fort du signal de données reproduites selon le premier code de détection du signal de données reproduites de manière à produire un premier signal de détection, et le deuxième moyen de détection d'erreur (52) est actif pour détecter une erreur des $m_2$ bits de poids faible du signal de données reproduites de manière à produire un deuxième signal de détection.

6. Dispositif selon la revendication 5, comme dépendante de la revendication 1 ou de l'une quelconque des revendications 3 et 4, comme dépendantes de la revendication 1, incluant un moyen de dissimulation (53) pour dissimuler une erreur dans le signal de données reproduites quant le premier ou le deuxième signal de détection est produit.

7. Dispositif selon l'une quelconque des revendications 2 et 6, dans lequel le moyen de dissimulation (53) est constitué par un circuit de correction.

# FIG. 1

ANALOG INPUT **1** → A/D CONVERTER **2** → ERROR PROCESSING ENCODER **3** → RECORDING MODULATION ENCODER **4** → SYNC SIGNAL ADDER **5** → RECORDING CIRCUIT **6** → **7** **8**

# FIG. 2

RECORDING INPUT DATA → ERROR CORRECTION ENCODER **30**

FIRST DETECTION CODE CALCULATOR (UPPER $m_1$ BITS) **31** → FIRST DETECTION CODE ADDER (UPPER $m_1$ BITS) **33**

SECOND DETECTION CODE CALCULATOR (LOWER $m_2$ BITS) **32** → SECOND DETECTION CODE ADDER (LOWER $m_2$ BITS) **34**

EP 0 137 721 B1

# FIG. 3

REPRODUCING CIRCUIT — 12

TIME AXIS COMPENSATING CIRCUIT — 13

REPRODUCING DEMODULATION ENCODER — 14

ERROR PROCESSING CIRCUIT — 15

D/A CONVERTER — 16

ANALOG OUTPUT — 17

# F I G. 4

REPRODUCED DATA → ERROR CORRECTING CIRCUIT ~50

FIRST ERROR DETECTING CIRCUIT (UPPER $m_1$ BITS) ~51

SECOND ERROR DETECTING CIRCUIT (LOWER $m_2$ BITS) ~52

ERROR CONCEALMENT CIRCUIT ~53

CONTROL CIRCUIT ~55

REPRODUCING MODE SWITCHING SECTION ~60

# F I G. 5

MSB —

M(8) BITS

LSB —

DATA BITS

REDUNDANT BITS

$\ell_1$ (32 SAMPLES)

$\ell_2$ (2 SAMPLES)

# F I G. 6

MSB —

M(8) BITS

LSB —

UPPER(4)$m_1$ BITS | DATA BITS | REDUNDANT BITS

LOWER(4)$m_2$ BITS | DATA BITS | REDUNDANT BITS

$\ell_1$ (32 SAMPLES)

$\ell_2$ (2 SAMPLES)

# F I G. 7

BIT ERROR RATE

$10^{-1}$  $10^{-2}$  $10^{-3}$  $10^{-4}$  $10^{-5}$  $10^{-6}$

PROBABILITY OF ERROR CONTAINED IN DATA BIT OR REDUNDANT BIT

1

$10^{-1}$

$10^{-2}$

$10^{-3}$

$10^{-4}$

$10^{-5}$

$P_1$

$P_2$

4